# DEMANDE DE BREVET EUROPEEN

(11) **EP 2 141 706 A1**
(43) Date de publication de la demande: **06.01.2010**
(21) Numéro de dépôt: 08290660.3
(22) Date de dépôt: 04.07.2008
(51) Int. Cl.: G11C 5/00, G06F 13/00

(54) **Adaptateur de carte mémoire**

(71) Demandeur: Gemalto SA, 92190 Meudon (FR)
(72) Inventeur: Thill, Michel, 92197 Meudon Cedex (FR); Marseille, François-Xavier, 92197 Meudon Cedex (FR)
(74) Mandataire: Cour, Pierre

(57) **Abrégé**

Un dispositif adaptateur permet de connecter sur un même port deux dispositifs électroniques. Le dispositif permet de piloter deux dispositifs sur un unique port qui autorise la connexion d'un unique dispositif. Le dispositif adaptateur comporte un premier connecteur 2 destiné à être connecté à un dispositif hôte recevant ledit dispositif adaptateur, un deuxième connecteur 4 destiné à recevoir une carte à mémoire 3, un interrupteur S1 reliant le premier connecteur au deuxième connecteur, et un circuit d'interface de dispositif 51 relié au premier connecteur et commandant l'interrupteur S1 pour l'ouvrir ou le fermer en fonction des commandes qui arrivent sur le premier connecteur.

## Description

L'invention se rapporte un adaptateur de carte mémoire. Plus particulièrement l'invention se rapporte à un adaptateur permettant de connecter un deuxième dispositif sur un port de carte mémoire en plus d'une carte à mémoire.

La possibilité d'avoir de grande capacité de stockage sur des mémoires de type Flash a développé le marché des cartes à mémoire. Les cartes à mémoires sont conforment à différents standards parmi lesquels on peut citer le standard SD (Secure Digital). Le Standard SD, comme tous les standards de cartes à mémoire, définit un format de carte, un type de connecteur et un protocole de communication entre un dispositif hôte destiné à recevoir la carte SD et la carte SD. Par standard SD, il faut comprendre dans ce document les publications faites par la SD Card Association et incluant les documents de définition de « SD memory card, Physical layer specification », « SDI-fC memory card », « miniSD card », « microSD card », « SDIO card », et « SD host controller spécification », Certains standards de carte à mémoire utilise en outre un protocole de communication étendu qui permet d'utiliser des instructions supplémentaires pour utiliser des dispositifs différents des cartes à mémoires. Notamment, le standard SD comporte une extension de jeu de commandes appelée SDIO (pour Secure Digital Input Output device). Grâce à cette extension SDIO, il est possible de connecter au dispositif hôte des diverses interfaces d'entrée/sortie.

Dans le monde des cartes SD, il est connu d'utiliser une carte de type SDIO pour valider des services autre que du stockage de données. On parle aussi de SD-MCE (Secure Digital - Mobile Commerce Extension). Grâce à ce type de carte, il est possible d'avoir accès à des services autre que du stockage, par exemple de la télévision à péage, sur des appareils mobiles tels que, par exemple des téléphones portables ou des petits ordinateurs portables.

Cependant, les appareils mobiles disposent d'un seul port de carte à mémoire et l'évolution de ces appareils ne va pas dans le sens de rajouter un deuxième port. Ainsi un utilisateur désireux d'avoir un service de télévision à péage sur son téléphone ne peux garder en même temps une carte à mémoire destinée à faire du stockage de masse. Le fait qu'un utilisateur doive changer de carte en fonction de l'utilisation n'est pas souhaitable car le changement de carte oblige de ne pouvoir accéder la mémoire de masse que si l'on n'utilise pas le service de télévision. Or un utilisateur peut désirer stocker des informations pendant l'utilisation du service de télévision. En outre, le standard SD ne prévoit pas de pouvoir connecter en parallèle deux dispositifs sur un même port.

L'invention propose un dispositif adaptateur permettant de connecter sur un même port deux dispositifs électroniques. Ainsi le dispositif hôte s'adresse à un unique dispositif qui permet de réaliser d'une part une fonction électronique et d'autre part du stockage de masse. Plus généralement, l'invention apporte une solution pour piloter deux dispositifs sur un unique port qui autorise la connexion d'un unique dispositif.

Ainsi, l'invention est un dispositif adaptateur qui comporte un premier connecteur, un deuxième connecteur, un interrupteur et un circuit d'interface de dispositif. Le premier connecteur est destiné à être connecté à un dispositif hôte recevant ledit dispositif adaptateur. Le deuxième connecteur est destiné à recevoir une carte à mémoire. L'interrupteur relie le premier connecteur au deuxième connecteur. Le circuit d'interface de dispositif est relié au premier connecteur et commande l'interrupteur pour l'ouvrir ou le fermer en fonction des commandes qui arrivent sur le premier connecteur.

Préférentiellement, le dispositif comporte un circuit applicatif relié au circuits d'interface de dispositif. Le dispositif comporte un circuit d'interface hôte relié au deuxième connecteur pour communiquer avec la carte à mémoire. Le circuit d'interface de dispositif et le circuit d'interface hôte sont reliés entre eux pour échanger des données et élaborer des caractéristiques communes prenant en compte des caractéristiques de la carte et des caractéristiques propres au dispositif.

Selon un mode de réalisation particulier, le circuit d'interface de dispositif ferme l'interrupteur lorsqu'une commande est reçue sur le premier connecteur et le maintient fermé pour laisser passer la réponse de la carte lorsque la commande est à destination de la carte. En l'absence de carte, le circuit d'interface de dispositif répond à toutes les commandes. Le circuit d'interface de dispositif ferme l'interrupteur lorsqu'une commande est reçue sur le premier connecteur et ouvre l'interrupteur pour bloquer la réponse de la carte lorsque la commande est à destination du circuit applicatif.

L'invention sera mieux comprise, et d'autres particularités et avantages apparaîtront à la lecture de la description qui va suivre, la description faisant référence aux dessins annexés, parmi lesquels :
la figure 1 représente un mode de réalisation préféré d'un adaptateur au format carte SD,
la figure 2 représente un schéma fonctionnel de l'invention,

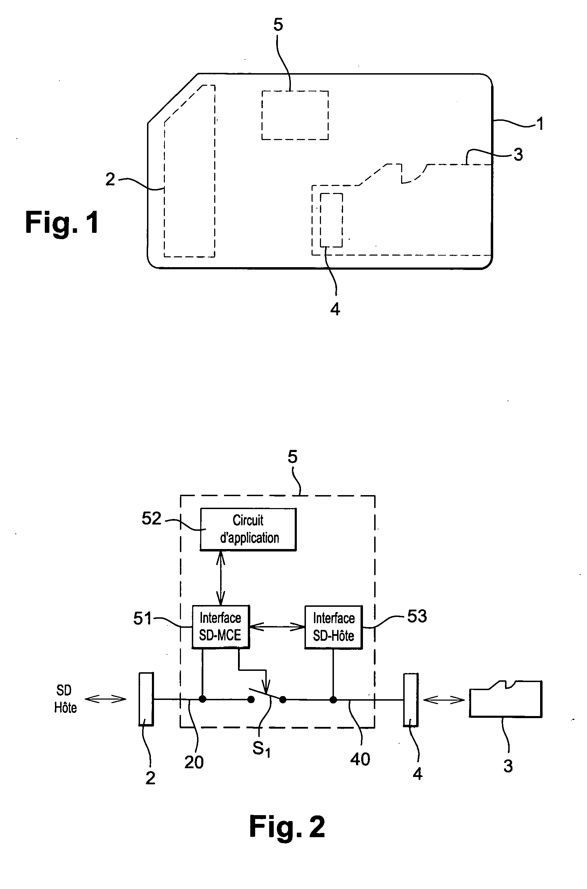

La figure 1 montre un exemple de réalisation préféré d'un adaptateur selon l'invention. L'adaptateur 1 est ici réalisé au format d'une carte mémoire SD. L'adaptateur 1 comporte un premier connecteur 2 au format d'un connecteur de carte SD. L'adaptateur 1 comporte un logement pour recevoir une carte mémoire 3 au format microSD qui est reliée par l'intermédiaire d'un deuxième connecteur 4. L'adaptateur 1 comporte une puce 5 reliée au premier et deuxième connecteur 2 et 4. La puce 5 contient les circuits électroniques de l'adaptateur 1. Dans le mode préféré de la figure 1, les circuits électroniques de l'adaptateur 1 sont tous placés sur une seule puce, toutefois, il est possible d'utiliser des circuits réalisés sur plusieurs puces.

La figure 2 détaille de manière fonctionnelle les circuits électroniques contenus dans la puce 5. Les premier et deuxième connecteurs 2 et 4 sont reliés à la puce, respectivement par un premier et un deuxième bus 20 et 40 contenant autant de connecteurs qu'il y a de contacts pour un connecteur de carte SD. Pour des raisons de clarté de dessin, un seul fil est représenté.

Les premier et deuxième bus sont reliés entre eux par l'intermédiaire d'un premier interrupteur S1 qui est constitué d'un ensemble d'interrupteur permettant de mettre en contact ou en circuit ouvert chaque conducteur des bus 20 et 40. L'interrupteur S1 permet ainsi soit d'assurer une liaison directe entre les deux connecteurs 2 et 4, soit de les isoler l'un de l'autre.

Un circuit d'interface de dispositif 51 est relié au premier bus 20. Le circuit d'interface de dispositif 51 est un circuit destiné à communiquer avec un hôte connecté au premier connecteur 2. C'est le circuit d'interface utilisateur qui assure la gestion du protocole de communication pour un circuit d'application 52. Le circuit d'application 52 peut être de n'importe quel type, par exemple un circuit de gestion de télévision à péage de type SD-MCE. D'autres circuits d'applications sont envisageables ; le circuit 52 peut être un modem disposant d'une autre connexion, un lecteur de carte à puce conforme à la norme ISO7816, ou encore n'importe quel autre type d'application pouvant être relié par un bus SD.

Le circuit d'interface de dispositif 51 analyse toutes les commandes échangées au niveau du premier connecteur 2. Cependant ce circuit d'interface ne répond pas à toutes les commandes. En effet, certaines commandes sont traitées directement par la carte 3. Le circuit d'interface est en outre relié à l'interrupteur S1 pour le commander et déterminer si la carte répond directement ou pas, en fonction des commandes observées.

Un circuit d'interface hôte 53 est relié, d'une part, au deuxième bus 40 et, d'autre part, au circuit d'interface de dispositif 51. Le circuit d'interface hôte 53 permet de contrôler la carte 3 lorsque l'interrupteur S1 est ouvert. La liaison entre le circuit interface hôte 53 est relié au circuit interface de dispositif 51 pour pouvoir intégrer des informations provenant de la carte 3 à des informations retournées par le dispositif interface de dispositif 51.

Au démarrage, l'adaptateur 1 se présente à l'hôte qui le reçoit comme un unique dispositif intégrant à la fois les caractéristiques propres au circuit d'application 52 et les caractéristiques de la carte 3. Durant cette phase de démarrage, le même principe que précédemment expliqué est mis en oeuvre, toutefois, il convient également d'anticiper certaine commande du dispositif hôte vis à vis de la carte.

Le tableau ci-après détaille chronologiquement les échanges de commandes et réponses lors de la phase de démarrage ou d'initialisation. Les commandes et réponses indiquées dans le tableau ainsi que les registres d'état mentionnés sont définis dans le standard SD auquel l'homme du métier peut se référer pour plus de détail.

| Commande envoyé par Hôte SD | Réponse de l'interface 51 | Traitement effectué par interfaces 51 et 53 | Etat de S1 | Commande envoyées par interface 53 | Réponse carte 3 |
|---|---|---|---|---|---|
| Cmd0 | | | Fermé | | |
| Cmd8 | | | Fermé | | |
| | | | Fermé | | R7 |
| Acmd41 | | | Fermé | | |
| | Busy | Mémorisation des informations de la réponse de la carte 3 dans le registre OCR de l'interface 51 | Ouvert | | OCR |
| Acmd41 | | | Ouvert | Cmd2 | |
| | Busy | Mémorisation des informations de la réponse de la carte 3 dans le registre CID de l'interface 51 | Ouvert | | CID |
| Acmd41 | | | Ouvert | | |
| | OCR | | Ouvert | | |
| Cmd2 | | | Ouvert | | |
| | CID | | Ouvert | | |
| Cmd3 | | | Fermé | | |
| | | | Fermé | | RCA |
| Cmd9 | | | Fermé | | |
| | | Mémorisation des informations de la réponse CSD pour communication avec la carte 3 et des fonctionnalités du circuit | Fermé | | CSD |
| | | d'application 52 | | | |
| Cmd4 | | Mise à jour registre DSR dans l'interface 51 | Fermé | | Mise à jour DSR |

II est à noter que la concaténation des informations dans les registres CSD et OCR du circuit d'interface de dispositif 51 est faite de manière intelligente : Le Vdd est choisi pour correspondre à la fois à la carte 3 et à l'adaptateur 1, les courants maximum sont additionnés les vitesses de transfert sont déterminées en fonction du plus lent entre la carte et le circuit d'interface de dispositif 51, etc... Les registres CSD et OCR sont reconstitués pour présenter des caractéristiques qui sont compatibles à la fois avec la carte 3 et l'adaptateur 1.

Pour le registre CID, il convient également de faire une agrégation des données. Le fabricant de l'adaptateur et de la carte ne sont pas les mêmes. En outre la carte 3 est amovible par rapport à l'adaptateur et l'information d'identification n'est pas la même suivant que la carte soit présente ou pas.

En ce qui concerne le contenu du registre RCA, l'adaptateur doit mémoriser cette information car l'adresse fournie par la carte peut également servir à adresser le circuit applicatif.

A la fin de la phase de démarrage, le circuit de commutation 54 détecte la commande Cmd4 sur le bus 20 et maintient l'interrupteur S1 fermé. Ainsi, lorsque l'hôte SD envoie des commandes de lecture ou d'écriture ou d'autres commandes uniquement à destination de la carte 3, ces commandes sont directement reçues par la carte 3, le circuit d'interface 51 ne répond pas et laisse l'interrupteur S1 fermé de sorte que la carte répond directement. Eventuellement, si la réponse concerne un état de la carte qui peut-être utilisé dans un registre d'état du dispositif d'interface de dispositif 51, alors le circuit interface hôte 53 intercepte la réponse et transmet la ou les données au circuit d'interface de dispositif 51 pour mémorisation dans le registre concerné.

Si la commande reçue n'est pas une commande uniquement en rapport avec la carte 3 alors l'interrupteur S1 est ouvert dès que l'intégralité de la commande est passée. Le circuit interface hôte reçoit l'éventuelle réponse de la carte 3. Le circuit interface de dispositif 51 répondra, éventuellement en tenant compte de la réponse de la carte 3. Lorsque le circuit interface de dispositif 51 a fini de répondre, il referme l'interrupteur S1 se sorte que la carte puisse recevoir la commande suivante.

Lorsque l'hôte SD veut envoyer une ou plusieurs commandes à destination du circuit d'application 52, il doit utiliser un jeu de commandes étendu. Pour cela il envoie une commande, par exemple Cmd6, qui n'est pas supportée par la carte 3. Lorsque le circuit de commutation 54 détecte cette commande Cmd6, alors il ouvre le l'interrupteur S1. La carte 3, ayant reçu la commande Cmd6, peut répondre qu'elle ne supporte pas cette commande mais sa réponse n'est pas transmise à l'hôte SD. La réponse est faite par le circuit d'interface 51 puis l'interrupteur S1 est refermé pour que la carte puisse recevoir la commande suivante au cas où elle lui soit destinée.

En cas de coupure d'alimentation, l'adaptateur ré-effectue la phase de démarrage.

Il est également possible d'utiliser l'adaptateur sans la carte 3. Dans ce cas, lors de la phase de démarrage la carte ne répondra jamais aux commandes qui sont envoyées. Si l'on reprend le tableau précédent, cela se traduit par une absence de réponse aux commandes Cmd8 et Acmd41. La réponse à la commande Cmd8 est optionnelle et donc ne signifie pas l'absence de la carte. Par contre, l'absence de la réponse OCR dans un délai déterminé signifie qu'il n'y a pas de carte 3 et donc l'interface de dispositif 51 peut répondre avec son propre registre OCR immédiatement après la prochaine commande Acmd41.

Dans une variante, il est possible que le circuit d'application 52 ait besoin de stocker des informations sur la carte 3, Dans ce cas, il convient d'ouvrir l'interrupteur S1 et d'adresser la carte 3 à l'aide de l'interface hôte 53. Si pendant cette utilisation de la carte 3, l'hôte SD envoie une commande à destination de la carte, le circuit d'interface de dispositif répondra que la carte n'est pas disponible en utilisant la réponse « busy ».

L'exemple précédemment décrit fait référence à un adaptateur au format d'une carte SD et recevant une carte microSD. Ces facteurs de formes peuvent être modifier. Une carte au format SDIO peut disposer d'une partie de taille plus importante qu'une carte SD et il est possible de remplacer la carte microSD 3 par tout autre format de carte SD ou miniSD.

Comme précédemment indiqué également le circuit d'application 52 peut être de tout type supporté par le standard SDIO et il est possible que le circuit d'application 52 dispose d'une connexion vers un autre circuit externe.

Toujours dans ce mode de réalisation préféré, la puce 5 correspond à un ensemble de circuits électroniques réalisés sur une seule puce. II est évident que, suivant le type d'application mis en oeuvre par l'adaptateur, les circuits électroniques peuvent être réalisés sur plusieurs puces distinctes.

Le problème posé ainsi que le mode de réalisation préféré sont relatif au standard SD. Toutefois, il existe d'autre standard de carte mémoire qui ont des caractéristiques similaires au standard 5D et pour lesquels le même problème se pose et ou une solution de même nature est applicable. A partir du moment où un standard de carte mémoire autorise la communication avec autre chose qu'une carte à mémoire et que le protocole de communication n'autorise la communication qu'avec un seul dispositif, l'utilisation d'un adaptateur, de même nature est utilisable. Il conviendra d'utiliser d'autres commandes propres au standard utilisé.

## Revendications

1. Dispositif adaptateur (1) **caractérisé en ce qu'**il comporte :
- un premier connecteur (2) destiné à être connecté à un dispositif hôte recevant ledit dispositif adaptateur,
- un deuxième connecteur (4) destiné à recevoir une carte à mémoire (3),
- un interrupteur (S1) reliant le premier connecteur au deuxième connecteur,
- un circuit d'interface de dispositif (51) relié au premier connecteur et commandant l'interrupteur (S1) pour l'ouvrir ou le fermer en fonction des commandes qui arrivent sur le premier connecteur.

2. Dispositif selon la revendication 1, lequel comporte en outre un circuit applicatif (52) relié au circuit d'interface de dispositif (51).

3. Dispositif selon la revendication 1 ou 2, lequel comporte en outre un circuit d'interface hôte (53) relié au deuxième connecteur (4) pour communiquer avec la carte à mémoire (3).

4. Dispositif selon la revendication 3, dans lequel le circuit d'interface de dispositif (51) et le circuit d'interface hôte (53) sont reliés entre eux pour échanger des données et élaborer des caractéristiques communes prenant en compte des caractéristiques de la carte (3) et des caractéristiques propres au dispositif.

5. Dispositif selon la revendication 1, dans lequel les premier et deuxième connecteurs sont conformes à un standard de carte SD.

6. Dispositif selon la revendication 5, dans lequel le dispositif adaptateur est au format SD standard et la carte à mémoire est au format micro SD.

7. Dispositif selon la revendication 1, dans lequel le circuit d'interface de dispositif (51) ferme l'interrupteur (3) lorsqu'une commande est reçue sur le premier connecteur (2) et le maintient fermé pour laisser passer la réponse de la carte (3) lorsque la commande est à destination de la carte.

8. Dispositif selon la revendication 7, dans lequel, en l'absence de carte (3), le circuit d'interface de dispositif répond à toutes les commandes.

9. Dispositif selon la revendication 2, dans lequel le circuit d'interface de dispositif (51) ferme l'interrupteur (3) lorsqu'une commande est reçue sur le premier connecteur (2) et ouvre l'interrupteur pour bloquer la réponse de la carte (3) lorsque la commande est à destination du circuit applicatif (52).
